# EUROPEAN PATENT SPECIFICATION

(11) **EP 0 474 369 B1**
(45) Date of publication and mention of the grant of the patent: **05.03.1997**
(21) Application number: 91307279.9
(22) Date of filing: 08.08.1991
(51) Int. Cl.: C23C 16/26, C23C 16/02, C23C 14/06

(54) **Diamond-like carbon coatings**
Diamantartige Kohlenstoffbeschichtungen
Revêtements de i-carbone

(30) Priority: 01.09.1990 GB 9019219
(43) Date of publication of application: 11.03.1992
(73) Proprietor: AEA Technology plc, Didcot, Oxfordshire OX11 0RA (GB)
(72) Inventor: Dearnaley, Geoffrey, Abingdon, Oxfordshire (GB)
(74) Representative: Wood, Paul Austin

(56) References cited:
- EP-A- 0 259 791
- EP-A- 0 372 696
- GB-A- 2 122 224
- US-A- 4 656 052

## Description

The present invention relates to the deposition of hard carbon coatings and in particular those which have a structure similar to that of diamond.

Because of their potential for high wear resistance, low coefficient of friction and chemical virtues, hard and coherent layers of carbon are being investigated for a variety of tribological applications. Ideally, the coatings should be of diamond, but it has proved difficult to deposit continuous crystalline diamond layers with good adherence upon certain technologically important substrate materials. These difficult materials include steels, nickel alloys, cobalt cemented tungsten carbide and most substances containing transition metal elements. Substrate materials favourable for the deposition of diamond include diamond itself, silicon, silicon carbide and other materials in which it is believed that conditions are present which enable hetero-epitaxy to occur.

An alternative to the deposition of diamond is the deposition of so-called diamond-like carbon coatings. Diamond-like carbon is distinct from both diamond and graphite. It is amorphous and is characterised by having planar Sp₂ interatomic bonding (as in graphite) rather than Sp₃ bonding (as in diamond) but it has a hardness approaching that of diamond. The mechanical, optical and other characteristics of diamond-like carbon stem from its amorphous nature and the absence of graphitic microcrystallites.

A method of depositing carbon by an ion-assisted process has been described previously in United Kingdom patent specification 2,122,224. In this process a source of hydrocarbon vapour is placed in a vacuum chamber near to work-pieces that simultaneously are bombarded with energetic ions, for example, nitrogen ions. The ion bombardment causes the decomposition of hydrocarbon molecules on the surface of the work-pieces to provide a coating of hard and adherent carbon.

However, this procedure does not always produce amorphous diamond-like carbon. By means of laser Raman spectroscopy it has been shown that this is so only on favourable substrate materials such as silicon, alumina, silicon nitride and other ceramics. In the case of steel, nickel, germanium and other similar materials it appears that the growth of graphitic microcrystals occurs and this is correlated with the formation of a soft coating with poor tribological properties.

EP 0 372 696 A₂ discloses a process for forming a layer of diamond-like carbon on a substrate in which a layer of silicon nitride is deposited upon a substrate by a plasma-activated vapour phase deposition process, followed by a similarly deposited layer of diamond-like carbon. The purpose of the layer of silicon nitride is to isolate the substrate from the layer of diamond-like carbon so as to prevent damage to, or contamination of, the surface of the substrate by the diamond-like carbon, particularly if fluorine is incorporated into the diamond-like carbon as may be done to control the resistivity and/or transparency of the diamond-like carbon, or to improve its hydrophillic properties.

The present invention provides a method by means of which had diamond-like carbon coatings can be deposited in a wide range of substrates including those at present known to be unfavourable for the deposition of such coatings.

According to the present invention there is provided a method of forming a layer of diamond-like carbon upon a substrate, including the operation of providing a carbon-containing species in the region of the surface of the substrate and subjecting the substrate to irradiation with ions thereby to cause the formation of the layer of diamond-like carbon on the substrate, characterised in that there is included the operation of forming prior to the formation of the layer of diamond-like carbon, a foundation layer of a material known to be conducive to the formation of diamond-like carbon, the foundation layer being formed by providing in the region of the surface of the substrate a population of atoms of a first species of a material which is a component of the material of the foundation layer and irradiating the substrate with ions of a second species such as to react with the first species to form the foundation layer.

Suitable materials for the foundation layer are silicon nitride, silicon, alumina, and boron nitride.

Preferably, both the foundation layer and the layer of diamond-like carbon are deposited by means of an ion-assisted process.

The invention will now be described, by way of example, with reference to the accompanying diagrammatic drawing of an apparatus suitable for the performance of the invention.

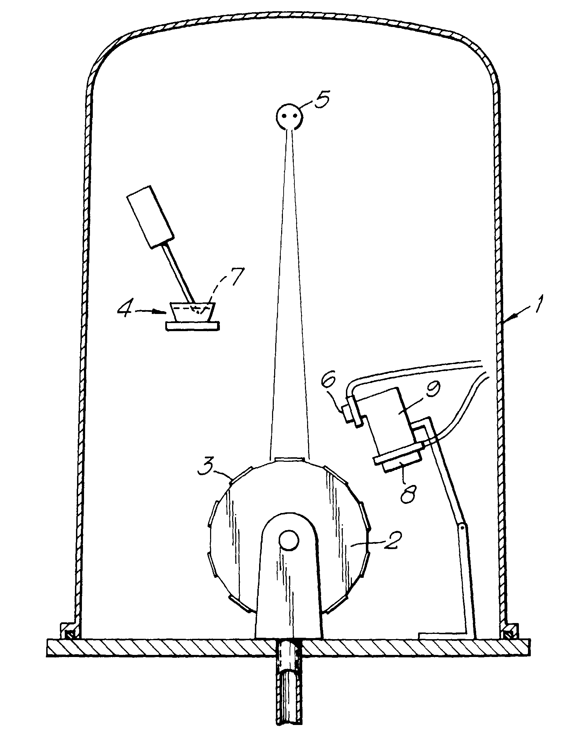

Referring to the drawing, a vacuum chamber 1 includes a rotatable support 2 for a number of workpieces 3, an electron beam heated hearth 4, an ion beam source 5 and a nozzle 6 through which hydrocarbon vapour can be directed at the workpieces 3.

In use, the workpieces 3 to be coated are placed on the support 2, a piece of a suitable material 7 for forming the foundation layer is placed upon the heath 4 and the vacuum chamber 1 is closed and evacuated to a pressure of some 10⁻⁶ Torr. Suitable materials are silicon, aluminium or boron. The electron beam to heat the hearth 4 is then switched on together with the ion beam source 5, which is such as to provide the ions (for example oxygen or nitrogen) which are required to form the desired material for the foundation layer. Suitable ion energies are in the range 40-80 KeV. The rates of arrival of coating atoms and ions at the workpieces 2 are adjusted to produce a coating of the required material upon the surface of the workpieces 3. When sufficient material has been deposited to form a complete foundation layer the ion beam hearth 4 is switched off, but the ion beam source 5 is kept running. A stream of hydrocarbon vapour is then directed at the workpieces 3 from the nozzle 6 while the surface of the workpieces 3 are bombarded with ions having an energy in the range 40-80 KeV and a beam current density of some 5µ A cm⁻² for a period of some 4 hours during which time the pressure in the vacuum chamber 1 is maintained at about 1.3 x 10⁻⁴ Pa (10⁻⁶ Torr). A suitable source for the hydrocarbon vapour is a quantity of polyphenyl ether 8 which is contained in a heated vessel 9 out of which the nozzle 6 leads.

If desired, the ion beam source 5 may be energised before the electron beam hearth 4 so as to enable the surfaces of the workpieces 3 to be cleaned by sputtering before the deposition of the foundation layer is begun.

The apparatus as described has a twin-anode ion source but other types of ion source such as that known as a bucket ion source can be used.

## Claims

1. A method of forming a layer of diamond-like carbon upon a substrate, including the operation of providing a carbon-containing species in the region of the surface of the substrate and subjecting the substrate to irradiation with ions thereby to cause the formation of the layer of diamond-like carbon on the substrate, characterised in that there is included the operation of forming prior to the formation of the layer of diamond-like carbon, a foundation layer of a material known to be conducive to the formation of diamond-like carbon, the foundation layer being formed by providing in the region of the surface of the substrate a population of atoms of a first species of a material which is a component of the material of the foundation layer and irradiating the substrate with ions of a second species such as to react with the first species to form the foundation layer.

2. A method according to Claim 1 characterised in that the first species is silicon, aluminium or boron and the second species is oxygen or nitrogen.

3. A method according to Claim 1 or Claim 2 characterised in that there is included the further operation of providing a carbon containing species in the region of the surface of the substrate and subjecting the substrate to further irradiation with the ions of the second species thereby to cause carbon atoms to be deposited upon the surface of the foundation layer as a diamond-like layer.

4. A method according to any of Claims 1 to 3 characterised in that the carbon-containing species is a hydrocarbon.

5. A method according to any of Claims 1 to 3 wherein the carbon-containing species is polyphenyl ether.

6. A method according to any of Claims 1 to 5 characterised in that the ions of the second species have energies in the range 40 - 80 Kev and a current density in the region of 5µAcm⁻².

7. A method according to any of Claims 1 to 6 characterised in that there is included the operation of irradiating the surface of the substrate upon which the layer of diamond-like carbon is to be formed with the ions of the second species to sputter clean the said surface prior to the formation of the foundation layer.

## Patentansprüche

1. Verfahren zur Herstellung einer Schicht aus diamantartigem Kohlenstoff auf einem Substrat einschließlich eines Schrittes, bei dem eine kohlenstoffhaltige Spezies im Oberflächenbereich des Substrats zur Verfügung gestellt und das Substrat mit Ionen bestrahlt wird, um die Bildung der Schicht aus diamantartigem Kohlenstoff auf dem Substrat zu bewirken, dadurch gekennzeichnet, daß vor der Ausbildung der Schicht aus diamantartigem Kohlenstoff eine Grundlagenschicht aus einem Material ausgebildet wird, von dem bekannt ist, daß es für die Bildung von diamantartigem Kohlenstoff förderlich ist, wobei die Grundlagenschicht dadurch hergestellt wird, daß man im Oberflächenbereich des Substrats eine Population von Atomen einer ersten Spezies aus einem Material, das eine Komponente des Materials der Grundlagenschicht ist, zur Verfügung stellt und das Substrat mit Ionen einer zweiten Spezies bestrahlt, damit diese mit der ersten Spezies reagieren und die Grundlagenschicht bilden.

2. Verfahren nach Anspruch 1, dadurch gekennzeichnet, daß die erste Spezies Silicium, Aluminium oder Bor und die zweite Spezies Sauerstoff oder Stickstoff ist.

3. Verfahren nach Anspruch 1 oder 2, dadurch gekennzeichnet, daß außerdem ein weiterer Schritt enthalten ist, bei dem eine kohlenstoffhaltige Spezies im Oberflächenbereich des Substrats zur Verfügung gestellt und das Substrat zusätzlich mit den Ionen der zweiten Spezies bestrahlt wird, damit Kohlenstoffatome als diamantartige Schicht auf der Oberfläche der Grundlagenschicht abgeschieden werden.

4. Verfahren nach einem der Ansprüche 1 bis 3, dadurch gekennzeichnet, daß die kohlenstoffhaltige Spezies ein Kohlenwasserstoff ist.

5. Verfahren nach einem der Ansprüche 1 bis 3, bei dem die kohlenstoffhaltige Spezies Polyphenylether ist.

6. Verfahren nach einem der Ansprüche 1 bis 5, dadurch gekennzeichnet, daß die Ionen der zweiten Spezies über eine Energie im Bereich von 40 bis 80 Kev und eine Stromdichte im Bereich von 5 µAcm⁻² verfügen.

7. Verfahren nach einem der Ansprüche 1 bis 6, dadurch gekennzeichnet, daß die Oberfläche des Substrats, auf dem die Schicht aus diamantartigem Kohlenstoff ausgebildet werden soll, zusätzlich mit den Ionen der zweiten Spezies bestrahlt wird, um diese Oberfläche vor der Ausbildung der Grundlagenschicht durch Vakuumzerstäuben zu reinigen.

## Revendications

1. Procédé de formation d'une couche de carbone analogue à du diamant sur un substrat, comprenant une opération de disposition d'une espèce contenant du carbone dans la région de la surface du substrat et d'application au substrat d'une irradiation par des ions de manière qu'il se forme une couche de carbone analogue à du diamant sur le substrat, caractérisé en ce que le procédé de formation comprend, avant la formation de la couche de carbone analogue à du diamant, l'incorporation d'une couche de fondement d'un matériau connu comme étant favorable à la formation du carbone analogue à du diamant, la couche de fondement étant réalisée par disposition, dans la région de la surface du substrat, d'une population d'atomes d'une première espèce d'un matériau qui est un élément constituant du matériau de la couche de fondement, et par irradiation du substrat par des ions d'une seconde espèce afin que celle-ci réagisse avec la première espèce et forme la couche de fondement.

2. Procédé selon la revendication 1, caractérisé en ce que la première espèce est le silicium, l'aluminium ou le bore, et la seconde espèce est l'oxygène ou l'azote.

3. Procédé selon la revendication 1 ou 2, caractérisé en ce qu'il comprend une opération suivante de disposition d'une espèce contenant du carbone dans la région de la surface du substrat et l'application au substrat d'une irradiation supplémentaire par les ions de la seconde espèce de manière que des atomes de carbone se déposent à la surface de la couche de fondement sous forme d'une couche analogue à du diamant.

4. Procédé selon l'une quelconque des revendications 1 à 3, caractérisé en ce que l'espèce contenant du carbone est un hydrocarbure.

5. Procédé selon l'une quelconque des revendications 1 à 3, dans lequel l'espèce contenant du carbone est un éther polyphénylique.

6. Procédé selon l'une quelconque des revendications 1 à 5, caractérisé en ce que les ions de la seconde espèce ont des énergies comprises entre 40 et 80 keV et une densité de courant d'environ 5 µA/cm².

7. Procédé selon l'une quelconque des revendications 1 à 6, caractérisé en ce qu'il comprend une opération d'irradiation de la surface du substrat sur lequel doit être formé la couche de carbone analogue à du diamant par des ions de la seconde espèce afin que la surface soit nettoyée par pulvérisation avant la formation de la couche de fondement.
